Europäisches Patentamt

European Patent Office

Office européen des brevets

(11) Publication number: **0 213 716 B1**

# EUROPEAN PATENT SPECIFICATION

(45) Date of publication of patent specification: **02.10.91**

(51) Int. Cl.⁵: **H01J 37/34, C23C 14/34**

(21) Application number: **86305690.9**

(22) Date of filing: **24.07.86**

(54) **Method and apparatus for removing short-circuiting deposits from high-voltage cathodes in a sputtering chamber.**

(30) Priority: **26.07.85 US 759381**

(43) Date of publication of application:
**11.03.87 Bulletin 87/11**

(45) Publication of the grant of the patent:
**02.10.91 Bulletin 91/40**

(84) Designated Contracting States:
**BE DE FR GB IT SE**

(56) References cited:
**US-A- 4 349 409**

(73) Proprietor: **WESTINGHOUSE ELECTRIC COR-PORATION**
**Westinghouse Building Gateway Center**
**Pittsburgh Pennsylvania 15235(US)**

(72) Inventor: **Phifer, Clarence Gary**
**6407 Percival Road**
**Columbia South Carolina 29206-5160(US)**

(74) Representative: **van Berlyn, Ronald Gilbert**
**23, Centre Heights**
**London, NW3 6JG(GB)**

## Description

The present invention relates to a method and arrangement for removing short-circuiting deposits from target electrodes in a sputtering chamber as described in the first parts of the claims 1 and 8.

Sputtering is a process employed for depositing coatings upon substrates. Typically, it involves introducing an inert gas into a vacuum chamber containing an anode, a substrate to be coated, and a target cathode, and applying a relatively high DC voltage across the anode and target cathode to cause the inert gas molecules to become ionized and to form a plasma. The ionized gas molecules will strike the target cathode, thereby causing atoms and/or molecules thereof to be sputtered from its surface. The substrate is positioned to intercept the sputtered target material, causing it to be deposited thereon as an adherent coating.

US-A-4,080,281 discloses a sputtering apparatus for making metal films, such as electrical resistors or electrodes of electrical capacitors, in which the substrates are placed in a cylindrical cage which serves as the anode. An outer coaxial, cylindrical target cathode circumferentially surrounds the cage to sputter radially inward toward the cage from all directions. An inner coaxial, rod target cathode extends along the cage's longitudinal axis to sputter radially outward in all directions. The cage rotates in order to cause the metal films to be more uniform.

US-A-3,562,140 and US-A-3,632,494 disclose sputtering apparatus for coating razor blades with chromium.

Sputtering devices are also used to coat nuclear fuel pellets. As known to those skilled in the nuclear reactor art, the life of a nuclear fuel assembly can be extended by combining an initially larger amount of fissile material with a calculated amount of a burnable neutron absorber. Burnable absorbers are materials (such as zirconium diboride, boron, gadolinium, samarium, europium, and the like) which have a high probability (or cross-section) for absorbing neutrons, resulting in isotopes of sufficiently low neutron capture cross-section to be substantially transparent to neutrons, all while producing no new or additional neutrons. The burnable absorber compensates for the larger amount of fissile material during the early life of the fuel assembly. During reactor operation, the effect of the burnable absorbers progressively decreases, resulting in a longer fuel assembly life at a relatively constant fission level. Longer fuel assembly life means less frequent nuclear-reactor fuel-assembly replacement which is a costly and time-consuming process.

Applicant's US-A-3,427,222 discloses a method of fusion-bonding a layer of burnable absorber material, also known as burnable poison, to the surface of a nuclear fuel pellet, and Applicant's US-A-4,587,088 and US-A-4,560,462 disclose a method and an apparatus, respectively, for sputter-coating nuclear fuel pellets.

US-A-4.349.409 discloses a method and an apparatus for plasma etching semiconductor materials by providing an intermediate electrode between the electrodes in a parallel state type plasma etching apparatus, moving the intermediate electrode by a drive mechanism, and continuously changing from a condition of high RF-input power and high self-bias voltage to a condition of low RF-input power and low self-bias voltage while varying the distance between the intermediate electrode and the first electrode and the RF power, thereby to remove damage or deposits that may have been formed on the surface when the semiconductor material was being subjected to processing.

During the sputtering process, a flake of accumulated absorber material stray-deposited on a surface other than a fuel pellet may occasionally spall off and fall onto one of the sputtering cathodes. Such flake will constitute a resistive conductor which may short out the high voltage to that cathode and quench the plasma of vaporized neutron absorber in the vacuum chamber.

In a typical sputtering chamber, the DC power source employed can supply up to about 17 A (amperes) at approximately 480 V (volts). A minimum of about 200 V (volts) is required to start and/or maintain a sputtering plasma. Whenever a flake of burnable neutron absorber, such as zirconium diboride, shorts the cathode to ground, the voltage will fall to anywhere from zero up to 25 V (volts) DC, while the current between the cathode and ground will rise to the maximum current of the power supply, namely, about 17 A (amperes). Although this small amount of power my suffice to make the flake glow and thereby render it clearly visible, only very rarely will it generate enough heat to clear the short circuit because shorting flakes usually are large and thick and therefore difficult to vaporize. Therefore, in a conventional sputtering chamber, the presence of a shorting flake between the cathode and ground requires that the sputtering chamber be shut down and cleaned out. Since the chamber operates at a very high vacuum on the order of 4 mPa (30 microtorr), it normally takes as long as six hours to cool down the sputtering apparatus, open up the vacuum chamber, clean out the system, pump the vacuum chamber down to 4 mPa (30 microtorr) again, and then reapply the appropriate voltage profile to create a high voltage sputtering plasma.

It is the principal object of the invention to provide ways and means enabling short-circuiting deposits, such as, flakes of sputtered material, to be removed much more efficiently and quickly.

The invention, from one aspect thereof, accordingly resides in a method of removing a short-circuiting deposit of conductive material from a sputtering cathode assembly disposed in a sputtering chamber and energized from a source of DC power sufficient to create and maintain a sputtering plasma, characterized by the steps of (a) interrupting the supply of DC power from the DC power source to the cathode assembly, and (b) applying to the cathode assembly electrical energy sufficient to vaporize said deposit and insufficient to create a sputtering plasma.

The electrical energy for vaporizing the short-circuiting deposit is supplied from a high-power AC source having an output voltage insufficient to create a sputtering plasma. Preferably, it is supplied for a predetermined period of time normally sufficient for vaporizing the short-circuiting deposit, and after which the power supply from the DC power source to the cathode assembly is resumed. If the short-circuit on the cathode assembly then is found still to exist, the sequence of interrupting the DC power supply, applying the vaporizing energy, and resuming the DC power supply may be repeated a predetermined number of times whereupon the sputtering chamber preferably is shut down for manual clearing of the short if the latter still persists.

The invention, from another aspect thereof, resides in an arrangement for removing a short-circuiting deposit of conductive material from a sputtering cathode assembly disposed within a sputtering chamber and connected to a source of DC power sufficient to create and maintain a sputtering plasma in the sputtering chamber, characterized by an auxiliary power source capable of supplying electrical energy sufficient to vaporize the short-circuiting deposit and insufficient to create a sputtering plasma; and means for connecting alternatively one of the DC and auxiliary power sources to said cathode assembly.

The connecting means includes switching means between the cathode assembly on the one hand and the DC and auxiliary power sources on the other, and control means for operating the switching means in a manner such as to interrupt the power supply from the DC power source to the cathode assembly and connect the latter to the auxiliary power source when the cathode assembly becomes short-circuited, and to disconnect the auxiliary power source from the cathode assembly and restore to the latter the power supply from the DC power source when the short-circuit on the cathode assembly has disappeared. The switching means may be relay-operated switches, with the control means including a selector switch operable to effect actuation of the appropriate relay-operated switches. For some applications, the control means for actuating the switching means in the desired manner preferably comprises an automatic system which continuously monitors certain short-circuit reflecting parameters, such as the voltage across the cathode assembly and the current supplied from the DC power source, and automatically operates the switching means based upon whether the monitored quantities indicate a presence or an absence of a short-circuit on the cathode assembly. If monitoring indicates that a short-circuit condition persists after completion of a switching sequence such as set forth above, the control system preferably will cause the same switching sequence to be repeated and eventually shut-down the sputtering chamber and/or issue a warning or alarm if after repeating the sequence a predetermined number of times the short-circuit condition still persists.

A preferred embodiment of the invention will now be described, by way of example only, with reference to the accompanying drawings, in which:-

Figure 1 is a schematic view of a sputter coating apparatus with which the invention may be used;

Figure 2 is a schematic view similar to Figure I but showing a drum of the apparatus retracted from its sputtering chamber;

Figure 3 is a schematic sectional view taken along lines III-III of Figure 1;

Figure 4 is a front perspective view of a lower portion of the open sputtering chamber with two stationary, lower target assemblies disposed therein;

Figure 5(a)-(d) are partial, sectional views illustrating details of four variations of the gap disposed between cathode and ground shield of one of the target assemblies;

Figure 6 is a schematic diagram of a power supply for the cathode assemblies of the apparatus; and

Figure 7 is a simplified schematic of a process control system for controlling the power supply of Figure 6.

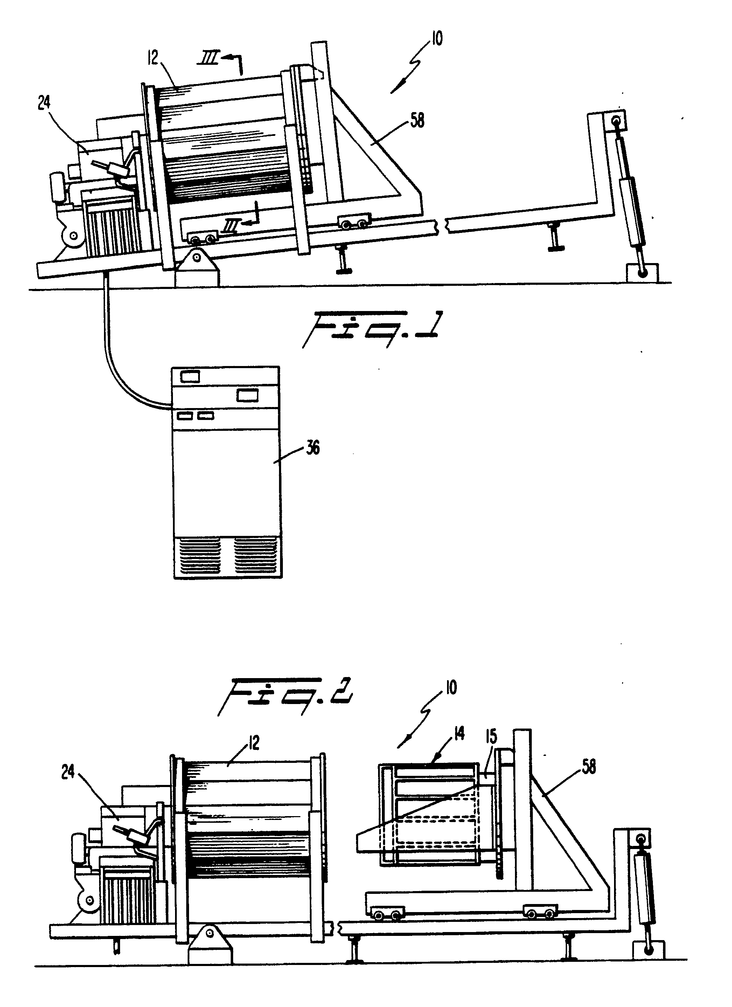

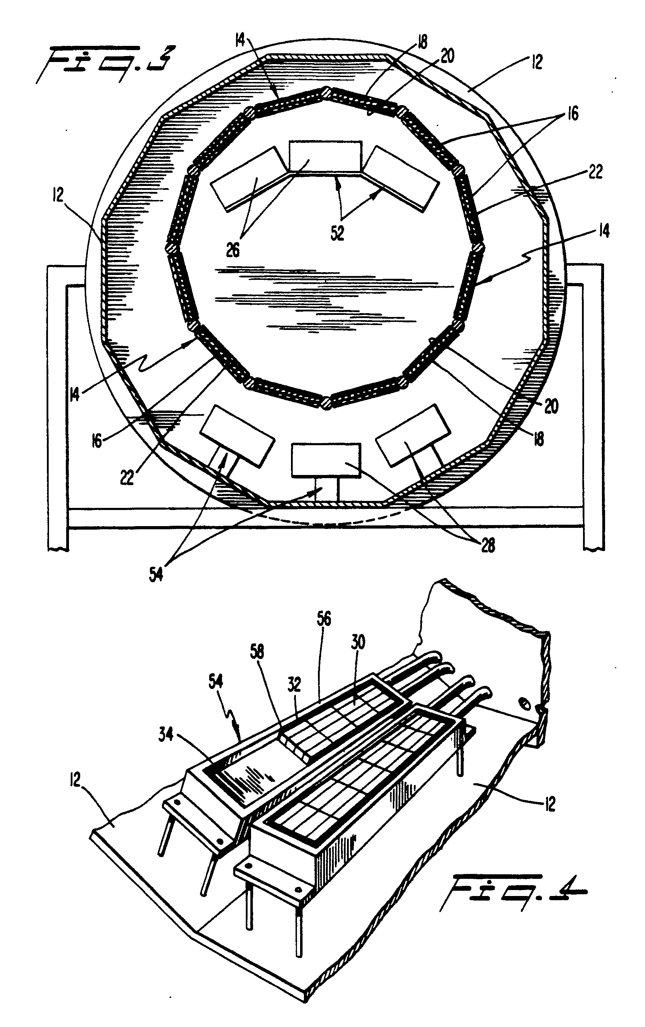

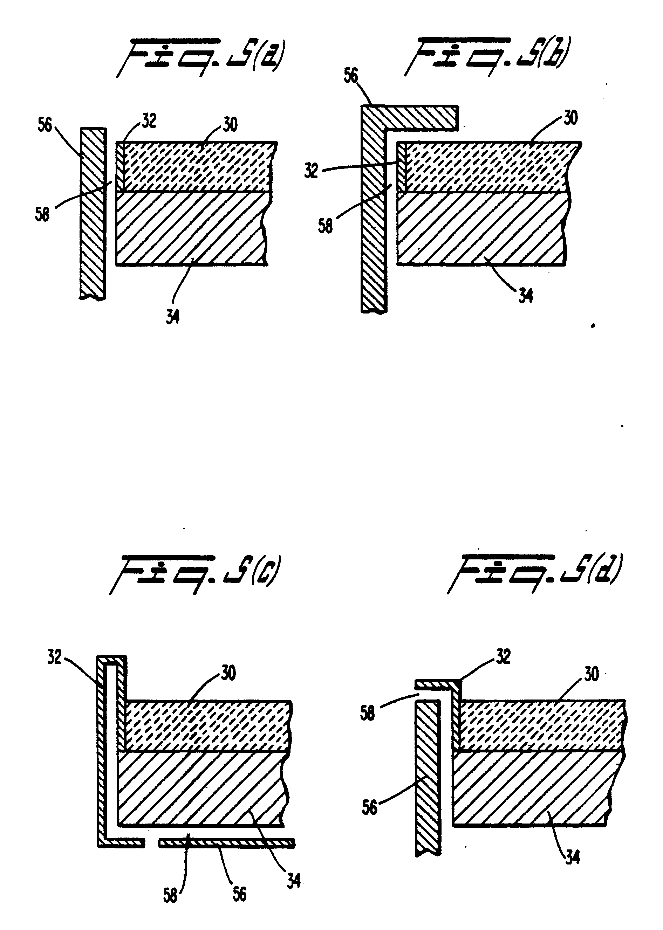

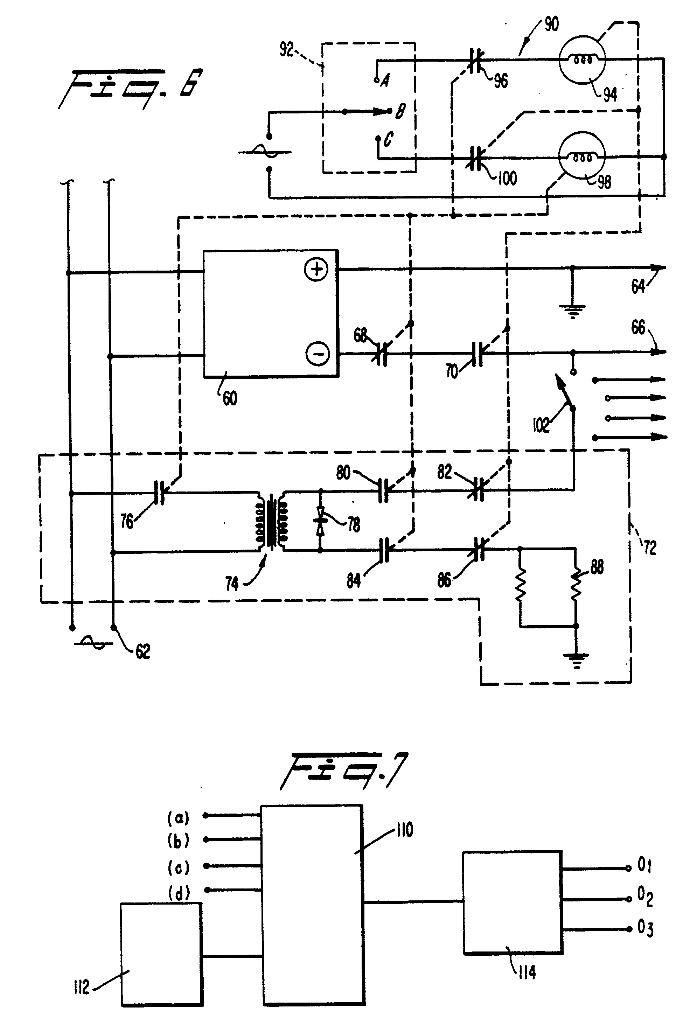

Referring now to the drawings, and to Figs. 1 to 5 in particular, the sputtering apparatus illustrated therein and generally designated with reference numeral 10 will be described in conjunction with coating nuclear fuel pellets. This apparatus 10, which is of the type described in detail in Applicant's above-mentioned US-A-4,560,462, includes a vacuum chamber 12 and a generally cylindrical, skeletal drum 14 which is slowly rotatable about its longitudinal axis by a motor 15 and is hermetically sealable within the vacuum chamber 12. Fig. 1 illustrates the apparatus with the drum 14 inserted in the vacuum chamber 12, and Fig. 2 shows the drum 14 withdrawn from the vacuum chamber 12. The longitudinal axis of the drum 14 may be oriented generally horizontally but preferably is tilted. As best seen from Fig. 3, a plurality of pallets 16 are detachably mounted circumferentially on the drum 14. The coating apparatus 10 includes a sputtering machine 24 having at least one stationary upper target 26 and at least one stationary lower target 28. Preferably, each of the targets 26 and 28 includes a plurality of target tiles 30 (Fig. 4) made of a material to be sputtered onto the nuclear fuel pellets 22 as a coating. A control console 36 (Fig. 1) is used to control the drum motor 15 and the sputtering machine 24.

Typically, each of the fuel pellets 22 (Fig. 3), consisting of a fissile material, such as uranium dioxide, may have the form of a right circular cylinder and approximately 13.5 mm long and 8.2 mm in diameter, and may weigh 7.8 g. The objective of the sputtering process is to cover the pellets 22 with a coating of a burnable absorber, such as for example, a 0.01 mm thick coating of zirconium diboride ($ZrB_2$).

Each of the pallets 16, as schematically indicated in Figure 3, consists of two generally rectangular screened parts 18 and 20 separably attached to each other and disposed face-to-face so as to define therebetween a space for accommodating the fuel pellets, preferably in a single layer in order to avoid problems such as pellet chipping, non-uniform pellet coatings, and the like. The pallets 16 are preferably made of stainless steel to which sputtered zirconium diboride will not firmly adhere.

The pellets 22 are sputter-coated by means of the sputtering machine 24 having the drum 14, including the pallets 16, and the chamber 12 as an anode, and having upper sputtering or target cathode assemblies 52 for supporting the stationary upper targets 26 such that, when the drum 14 is placed in the chamber 12, the upper targets 26 are disposed inside the drum 14 proximate to the inner periphery and above the longitudinal axis, i.e. the axis of rotation, thereof. The stationary upper targets 26 face generally upward and radially outward. The sputtering machine 24 also includes lower sputtering or target cathode assemblies 54 for supporting the stationary lower targets 28 such that, when the drum 14 is placed in the chamber 12, the lower targets 28 are disposed outside the drum proximate to the outer periphery and below the longitudinal axis thereof, and with the lower targets 28 facing generally upward and radially inward. The target tiles 30 on each cathode assembly 52 or 54 are held in place by a metallic retainer strip 32 (Fig. 4 and Figs. 5a-d) surrounding them.

During operation, and as the drum 14 is rotating, coating material will be sputtered onto the fuel pellets 22 alternately from the upper targets 26 and the lower targets 28 each time the respective pallets 16 containing the fuel pellets travel thereupon.

Although sputtering could be accomplished with a single upper target 26 and a single lower target 28, it is preferred to have several upper targets and several lower targets, as illustrated herein, in order to achieve a higher coating rate.

In a typical sputtering apparatus, the zirconium diboride sputtering rate per cathode pair may be 10 $\mu m$ (microns) (final coating thickness) in 28 to 30 hours, with rectangular targets each measuring 68.5 $\times$ 12.7 cm and employing 4 columns and 6 rows of zirconium diboride rectangular tiles each measuring 11.4 $\times$ 3.2 cm and having a thickness of 3.75 mm. Preferably, the tiles 30 on each target 26 or 28 (Fig. 4) are identical to, and hence interchangeable with each other.

Each of the upper and lower cathode assemblies 52, 54 within the vacuum chamber 12 comprises a copper base 34 (Fig. 5) which is liquid cooled and supports the target tiles 30. A permanent magnet (not shown) may be positioned beneath the targets to provide a directing force for the plasma resulting when a high DC voltage is applied between the cathode assemblies 52 and 54 and ground (anode) in the presence of a very thin Argon atmosphere. As mentioned hereinbefore, the pallets 16 containing the pellets 22 are connected to ground.

Each cathode assembly 52 or 54 includes a metallic ground shield 56 which is electrically isolated from the target 26 or 28 by a gap 58. In Figs. 4, 5a, 5b and 5d, the ground shield 56 is shown surrounding the base 34, the tiles 30, and the tile retaining strip 32 of the respective target, and in Figs. 4, 5a and 5b the gap 58 is shown as open at the top of the target, namely, in Figs. 4 and 5a as open in the same direction in which coating material is sputtered from the exposed surface of the layer of tiles 30, i.e. upward, and in Fig. 5b as open laterally inward toward the middle of the exposed surface of the layer of tiles 30. Both of these arrangements are at considerable risk of having their target or sputtering cathodes shorted by flakes of sputtered material, such as zirconium diboride, falling onto the target and bridging the gap between the ground shield 56 and the tile retaining strip 32 (Fig. 4 or 5a) or the ground shield 56 and the top of the layer of tiles 30 (Fig. 5b).

In Fig. 5c, the ground shield 56 and the gap 58 separating it from the target are disposed beneath the latter, the tile retaining strip 32 being extended to form a reverse bend and then to extend laterally alongside and partially underneath the target, there to terminate short of the ground shield 56 so as to keep the latter and the strip 32, hence the cathode, physically and electrically apart. Since this space separating the retaining strip 32 from the ground shield 56 is beneath the target and thus located at the side thereof opposite from that supporting the sputtering tiles 30, there is little likelihood of loose flakes of sputtered material bridging this space and thereby grounding the cathode.

The arrangement illustrated in Fig. 5d is similarly advantageous insofar as the tile retaining strip 32 has a portion extending laterally outward so as to form a ledge which overhangs the ground shield 56 and the gap 58 between the latter and the target and protects the gap 58 from being bridged by loose flakes of sputtered material falling onto the target.

As mentioned hereinbefore, whenever a flake of sputtered material falling onto a target does bridge the gap between the latter and its ground shield, it short-circuits the target cathode and thereby causes the plasma of vaporized and sputtered material (e.g. zirconium diboride) to be quenched, a re-igniting of such plasma then being possible only after the removal of the short-circuiting flake. Likewise as indicated hereinbefore, the invention provides a way and means permitting short-circuiting deposits, such as flakes of sputtered material, to be removed efficiently and without the need to break the vacuum in the vacuum chamber of the sputtering apparatus.

Broadly speaking, the concept of the invention is to vaporize a short-circuiting deposit by temporarily applying, from an auxiliary power source, electrical energy sufficient to quickly vaporize the flake but insufficient to initiate a sputtering plasma.

The invention is shown embodied in the circuit arrangement illustrated in Fig. 6 and comprising a DC power source 60, an auxiliary power source 72, and control means 90 for causing electrical energy to be supplied to the target cathode assemblies either from the DC power source 60 in order to create and/or maintain a sputtering plasma, or from the auxiliary power source 72 in order to vaporize a short-circuiting flake or similar deposit bridging the gap between the target and ground shield of one of the cathode assemblies within the sputtering chambers. More particularly, the DC power source 60 shown in Fig. 6 connected to an AC mains 62 provides an output voltage high enough to start and maintain a sputtering plasma.

For a typical sputtering device, the DC power supply 60 will produce a negative 600 V DC output from a 440 V AC source. Of course, 120 V or 220 V AC utility-supplied power sources can also be employed. Generally, at least minus 200 V (volts) is required to ignite and maintain a sputtering plasma.

The positive output terminal 64 of the power supply 60 is connected to the ground shield 56 which is connected to the common anode of the sputtering apparatus 10. The negative output terminal 66 is connected to an upper or lower one of the cathode assemblies 52 and 54 of the apparatus 10 through relay-operated switches 68 and 70. Preferably, each cathode assembly is individually energized (and, as further described hereinbelow, monitored) so that interruption of power to one cathode will not affect the other cathode assemblies and so that ground faults can be easily identified and eliminated. The relay-operated switch 68 is normally closed and the relay-operated switch 70 is normally open. The operation of these switches is described in detail below. As will be apparent to the artisan, electronic or mechanical switching means can be substituted for these relay-switches.

According to the invention, each of the cathode assemblies 52 and 54 is also connected to a high-power, low-voltage AC power source 72 through a switching arrangement. In the illustrated embodiment, the AC power source 72 comprises a step-down isolation transformer 74 connected to the mains 62 through a relay switch 76. While it is convenient to energize both the DC power supply 60 and the AC power supply 72 from the same mains, the two supplies 60 and 72 could be energized from separate sources, if desired.

Preferably, means such as a varistor 78 is connected across the secondary of the isolation transformer 74 to absorb and suppress transient voltages and voltage spikes. The transformer 74 preferably has a 60 V AC (at 10kVA) output winding which will provide sufficient power at low enough a voltage to vaporize any flake without producing uncontrolled ionization. Since, as explained above, about 200 V is required to ignite or maintain a plasma, the AC power source preferably is limited to a peak output of about 100 V to ensure pellet integrity. Preferably, a pair of relay-operated switches 80 and 82 is connected between the transformer secondary and the cathode connection 66, and another pair of relay-operated switches 84 and 86 is connected between the transformer secondary and ground. The use of two sets of series switches protects the transformer 74 from any high-voltage transients from the DC power supplies. In the illustrated embodiment, the switches 80 and 84 are normally open, and the switches 82 and 86 are normally closed. The operation of these switches is described below.

Preferably, there is provided a ballast load comprising one or more tungsten lamps 88. For a typical installation, the ballast load should be able to dissipate about 2.0 to 6.0 kW. Whenever the AC power source is energized, this ballast load will be in series with whatever flake may be shorting out the cathode assembly. In normal use, the flake will vaporize before the tungsten filament heats up to limit the current passing through the circuit. If the ballast is in the form of a lamp, it will serve the additional function of providing a visual indication any time a cathode assembly is shorted by something not as readily vaporized as a $ZrB_2$ flake, such

as a piece of loose metal or the like, for example.

Preferably, the DC and AC power supplies 60 and 72, respectively, are connected to the cathode assemblies under the control of a safety interlock system 90 which controls the above-mentioned relay-operated switches. The safety interlock system 90 preferably is powered from an AC main, such as a 120 V AC utility line, through a three-position selector switch 92 or equivalent device having a switch position "B" for disconnecting the power, a switch position "A" as a "run" position for maintaining the supply of DC power to the cathode assemblies, and a switch position "C" as a "clear short" position in which the AC power source is momentarily (e.g. 5-15 s(seconds)) energized and the DC power source is disconnected from the cathode assemblies. The switch position "C" may comprise a push-button or a timed switch which, when operated, establishes contact for only a predetermined time interval. In the switch position "A", current is supplied to a relay 94 through a normally closed switch 96; and in the switch position "C", current is supplied to a relay 98 through a normally close switch 100. The relay 94, when energized, opens the switches 100, 82 and 86 while closing switch 70, thereby causing power to be supplied to the cathode terminal 66 only from the DC power source 60. When the relay 94 is deenergized, the switches 100, 82, 86 and 70 will return to their normal positions. The relay 98, when energized, opens the switches 96 and 68 while closing the switches 76, 80 and 84, thereby causing power to be supplied to the cathode terminal 66 only from the AC power source 72 while disconnecting the DC power source 60 from the terminal 66.

The isolation transformer 74 is selected to provide up to 150-200 continuous A (amperes) at about 60 V AC. This power is more than sufficient to vaporize any conceivable $ZrB_2$ flake. For other applications, different requirements will present themselves. Since the applied AC voltage thus is low, i.e. 60 V, it will not ignite a plasma so that the integrity of the pellet purity will be preserved. In this regard, the peak AC voltage should be limited to a value which will not cause an arc between the cathode and ground when the flake is evaporated, and thereby create a risk of uncontrolled sputtering.

It should be noted that although the relay controlled-switching arrangement described above is preferred for many applications, other arrangements capable of ensuring that the DC power source is disconnected from the cathode terminal 66 while the AC power source 72 is connected thereto, and which would protect the sputtering equipment from electrical disturbances, would also fall within the scope of the claims.

As soon as a shorting flake is vaporized, the AC current flow to the cathode will automatically cease, and at this point it is safe to return to normal DC power operation and to restart the plasma generating operation in accordance with a predetermined voltage profile.

The illustrated embodiment illustrating only one DC power supply 60 is simplified for clarity. In practice, a plurality of high-voltage DC power supplies 60 may be used to energize the cathode assemblies 52 and 54. In the case of more than one DC power source and/or cathode assembly, a manually or electrically operable selector switch, such as switch 102, may be utilized for connecting a single high-current AC power source, such as source 72, selectively to the cathode assemblies requiring a flake-crested short to be cleared. Although a sufficiently large DC source can be used to energize several cathode assemblies, it is preferred to utilize a separate DC power source 60 for each cathode assembly in order that, in the event of failure of any are preferred is so that any one cathode assembly or its power source, the remaining cathode assemblies can continue the sputtering operation.

With the power supply of Figure 6, the operator of the sputtering apparatus would manually make and/or break all needed power connections through operation of the switch or switches 92. Such an arrangement is appropriate for a standby flake evaporation system which is not expected to be frequently used.

Where the cathode assembly configuration is such that frequent flake-related shorts are expected or a large number of cathode assemblies is being employed, an automatic system of the type illustrated in Figure 7 is preferable wherein various system parameter information inputs a, b, c, d are connected to an input/output device 110, such as a Keithley or an Acromag Data Acquisition device. Input "a" may represent the instantaneous voltage between the cathode terminal 66 (Fig. 6) and ground. Input "b" may represent the instantaneous current flowing in the cathode circuit. Input "c" may represent a timing clock. No separate timing clock input is necessary if a process controller having a programmable internal clock is used. Input "d" represents the output of a conventional residual gas analyzer (RGA) capable of detecting small concentrations of various gases. Specifically, the RGA should be capable of sensing the presence of nitrogen which would indicate that the vacuum in the vacuum chamber 12 has been broken, or the presence of water vapor which would indicate a water leak, for example, from the cathode assembly cooling system (not illustrated).

A programmed supervisory computer 112, such as an IBM PC/XT is used as a system controller to provide instructions for controlling sputtering chamber conditions such as sputtering rates, sputtering times, applied voltages, etc. in a manner well known to a person skilled in the art. The status of the system is monitored by a process controller 114, such as a Westinghouse 700B NumaLogic Process Controller. The controller 114 preferably has three logical outputs, namely, an output $O_1$ which is indicative of normal operation and, when present, will control the power supply to continue the sputtering process, an output $O_2$ which is indicative of a positive output from the RGA input "d" and, when present, will immediately shut down the sputtering process and preferably activate an alarm or other indication to alert the operator to the presence of a leak, and an output $O_3$ which is indicative of a short-circuit condition and, when present, will activate a short-circuit clearance sequence, as described below.

The output $O_3$ is triggered in accordance with predetermined short circuit criteria. For a typical sputtering process, a short circuit condition is defined as a voltage drop from the cathode terminal 66 to ground of less than about 25 V and a cathode current exceeding 12-15 A (amperes), where 17 A (amperes) is the maximum current of the DC source 60. Since such conditions may exist momentarily for various reasons unrelated to a flake short (for example during start-up arcing), output $O_3$ is only triggered if those conditions persist for at least a predetermined time period of, say, 1 s- (second), for example, which is preprogrammed into the process controller 114.

Upon the occurrence of a cathode assembly short, i.e., when there appears an output at $O_3$, the system controller 112 is preprogrammed to interrupt the flow of DC current to the shorted cathode assembly. After a delay of 1 to 5 s(seconds) introduced to prevent switch-over arcs, the power supply connections are switched, in a manner similar to that described above with regard to the safety interlock 90, to connect the AC source 72 to the shorted cathode assembly. The AC source 72 is then energized for a predetermined time period, for example, for about 5 to 15 seconds, in order to vaporize the shorting flake, while the information inputs a, b, c, d and the supervisory computer instructions are monitored.

After the lapse of the predetermined time period, the AC power source 72 is deenergized, and after a pause of about 1 to 5 s(seconds), introduced to prevent switch-over arcs, the connections between DC source 60 and the cathode terminal 66 are re-established and the AC source 72 is disconnected from the cathode terminal 66. The DC source 60 is then turned on in accordance with a predetermined voltage profile controlled by the system controller computer 112, and the cathode assembly conditions are monitored. If the conditions existing at the cathode assembly are acceptable, normal operation is continued. If the cathode assembly conditions are still not normal, indicating that a short circuit still exists, the above-described sequence is repeated but only for a limited number of attempts. If, after 3 to 5 attempts, for example, the short circuit condition remain, the system controller 114 will automatically shut down the sputtering apparatus and preferably will provide an indication that a repair is needed. Stubborn shorts which fail to disappear after several attempts are likely to be the result of a solid, metallic object shorting out the cathode assembly.

As mentioned initially herein, the preferred embodiment shown and described has been presented by way of example, only. Modifications possible within the scope of the claims would include substituting electronic switching schemes for the relay-operated switches illustrated, and substituting a single general-purpose computer for the two computers 112 and 114 indicated in Figure 7. Moreover, any suitable power source capable of being inserted into the cathode circuit and of providing the low-voltage, high-current power required to effect flake evaporation in accordance with the invention can be used.

## Claims

1. A method of removing a short-circuiting deposit of conductive material from a sputtering cathode assembly disposed in a sputtering chamber and energized from a source of DC power sufficient to create and maintain a sputtering plasma, characterized by the steps of (a) interrupting the supply of DC power from the DC power source to the cathode assembly, and (b) applying to the cathode assembly electrical energy sufficient to vaporize said deposit and insufficient to create a sputtering plasma.

2. A method according to claim 1, characterized in that said electrical energy is applied from a high-power AC source having an output voltage insufficient to create a sputtering plasma.

3. A method according to claim 1 or 2, characterized in that the step (b) is continued for a predetermined period of time normally sufficient for vaporizing the short-circuiting deposit, and is then followed by (c) the step of resuming the power supply from the DC power source to the cathode assembly.

4. A method according to claim 3, characterized by monitoring parameters indicative of short-circuiting of the cathode assembly, and repeating the steps (a) and (b) if the parameters being monitored during step (c) still indicate short-circuiting of the cathode assembly.

5. A method according to claim 4, characterized in that the steps (a), (b) and (c) are repeated a predetermined number of times, followed by shutting down the sputtering chamber if the parameters being monitored after repeating said steps (a), (b) and (c) said predetermined number of times still indicate short-circuiting of the cathode assembly.

6. A method according to claim 3, 4 or 5, characterized in that a first pause is introduced between the steps (a) and (b), and a second pause is introduced between the steps (b) and (c).

7. A method according to claim 3, 4, 5 or 6, characterized in that the step (c) includes ramping-up said DC power source according to a predetermined voltage profile.

8. An arrangement for removing a short-circuiting deposit of conductive material from a sputtering cathode assembly disposed within a sputtering chamber and connected to a source of DC power sufficient to create and maintain a sputtering plasma in the sputtering chamber, characterized by an auxiliary power source (72) capable of supplying electrical energy sufficient to vaporize the short-circuiting deposit and insufficient to create a sputtering plasma; and means (68-86, 90 or 110-114) for connecting alternatively one of the DC and auxiliary power sources (60 and 72) to said cathode assembly (52 or 54).

9. An arrangement according to claim 8, characterized in that said means for connecting include first switching means (68,70) connected between the DC power source (60) and the cathode assembly (52 or 54), second switching means (80-86) connected between the auxiliary power source (72) and the cathode assembly, and control means (90 or 110-114) for operating said first and second switching means in a manner such as to interrupt the power supply from the DC power source (60) to the cathode assembly (52; 54) and connect the latter to said auxiliary power source (72) when the cathode assembly becomes short-circuited, and to disconnect the auxiliary power source (72) from the cathode assembly and restore the power supply to the latter from said DC power source (60) when the short-circuit on the cathode assembly has disappeared.

10. An arrangement according to claim 9, characterized in that said first and second switching means (68,70; 80-86) are relay-operated switches, and said control means (90) includes a switch (92) selectively operable to effect actuation of the respective relay-operated switches.

11. An arrangement according to claim 9, characterized in that said control means (110-114) includes input-and-output means (110) for monitoring voltage and current conditions reflecting the presence and absence of short-circuiting of the cathode assembly, and a process controller (114) responsive to the output of said input-and-output means (110) for automatically actuating said first and second switching means in said manner.

12. An arrangement according to claim 8, 9, 10 or 11, characterized by short-circuit indicating means (88) providing an indication of persistent short-circuiting of the cathode assembly exceeding a predetermined duration.

13. An arrangement according to claim 8, 9, 10, 11 or 12, characterized in that said auxiliary power source (72) comprises a high-power AC source providing an output voltage insufficient to create a sputtering plasma.

14. An arrangement according to claim 13, characterized in that said high-power AC source (72) comprises a step-down transformer (74) with a secondary winding adapted to be connected to the cathode assembly (52 or 54) for supplying said electrical energy thereto.

15. An arrangement according to claim 14, characterized in that said secondary winding has connected in series therewith current-limiting ballast means (88) adapted to become effective with a predetermined time delay following connection of said high-power AC source (72) to the cathode assembly, said time delay exceeding the time span normally required to effect vaporization of the short-circuiting deposit.

16. An arrangement according to any one of claims 8 to 15 wherein said sputtering chamber contains more than one said cathode assembly, characterized in that said auxiliary power source (72) has associated therewith selector switch means (102) for connecting the auxiliary power source (72) selectively to any one of the cathode assemblies (52,54) within the sputtering chamber (12).

**Revendications**

1. Procédé d'enlèvement d'un dépôt court-circuitant de matière conductrice d'un assemblage de cathodes de pulvérisation disposé dans une chambre de pulvérisation et alimenté à partir d'une source d'énergie en courant continu suffisante pour créer et maintenir un plasma de pulvérisation, caractérisé par les étapes consistant à (a) interrompre l'alimentation en énergie en courant continu de l'assemblage de cathodes à partir de la source d'énergie en courant continu, et (b) appliquer à l'assemblage de cathodes une énergie électrique suffisante pour vaporiser ledit dépôt et insuffisante pour créer un plasma de pulvérisation.

2. Procédé selon la revendication 1, caractérisé en ce que ladite énergie électrique est appliquée à partir d'une source de courant alternatif de grande puissance présentant une tension de sortie insuffisante pour créer un plasma de pulvérisation.

3. Procédé selon la revendication 1 ou la revendication 2, caractérisé en ce que l'étape (b) est poursuivie pendant une période de temps prédéterminée normalement suffisante pour permettre la vaporisation du dépôt court-circuitant, et qu'elle est ensuite suivie de (c) l'étape consistant à recommencer à alimenter en énergie l'assemblage de cathodes à partir de la source d'énergie en courant continu.

4. Procédé selon la revendication 3, caractérisé en ce qu'il consiste à contrôler des paramètres représentatifs d'un court-circuitage de l'assemblage de cathodes, et à répéter les étapes (a) et (b) si les paramètres contrôlés au cours de l'étape (c) continuent d'indiquer un court-circuitage de l'assemblage de cathodes.

5. Procédé selon la revendication 4, caractérisé en ce que les étapes (a), (b) et (c) sont répétées un nombre de fois prédéterminé, ceci étant suivi par la mise à l'arrêt de la chambre de pulvérisation si les paramètres contrôlés après la répétition, suivant le nombre nombre prédéterminé de fois, des étapes (a), (b) et (c), continuent d'indiquer un court-circuitage de l'assemblage de cathodes.

6. Procédé selon la revendication 3, 4 ou 5, caractérisé en ce qu'une première pause est introduite entre les étapes (a) et (b), et en ce qu'une seconde pause est introduite entre les étapes (b) et (c).

7. Procédé selon la revendication 3, 4, 5 ou 6, caractérisé en ce que l'étape (c) comprend l'augmentation de la pente de ladite source d'énergie en courant continu suivant un profil de tension prédéterminé.

8. Système destiné à l'enlèvement d'un dépôt court-circuitant de matière conductrice d'un assemblage de cathodes de pulvérisation disposé à l'intérieur d'une chambre de pulvérisation et relié à une source d'énergie en courant continu suffisante pour créer et maintenir un plasma de pulvérisation dans la chambre de pulvérisation, caractérisé en ce qu'il comporte une source (72) d'alimentation en énergie auxiliaire capable de fournir une énergie électrique suffisante pour vaporiser le dépôt court-circuitant et insuffisante pour créer un plasma de pulvérisation; et des moyens (68 à 86, 90 ou 110 à 114) servant à raccorder alternativement l'une des sources d'énergie, à savoir la source de courant continu ou la source auxiliaire (60 ou 72), audit assemblage (52 ou 54) de cathodes.

9. Système selon la revendication 8, caractérisé en ce que lesdits moyens de raccordement comprennent des premiers moyens (68, 70) de commutation reliés entre la source (60) d'énergie en courant continu et l'assemblage (52 ou 54) de cathodes, des seconds moyens (80 à 86) de commutation reliés entre la source (72) d'énergie auxiliaire et l'assemblage de cathodes, et des moyens (90 ou 110 à 114) de commande servant à commander lesdits premiers et seconds moyens de commutation de manière à interrompre l'alimentation en énergie de l'assemblage (52; 54) de cathodes à partir de la source (60) d'énergie en courant continu et à relier ledit assemblage à ladite source (72) d'énergie auxiliaire lorsque l'assemblage de cathodes est court-circuité, ainsi qu'à débrancher la source (72) d'énergie auxiliaire de l'assemblage de cathodes et à rétablir l'alimentation en énergie de ce dernier à partir de ladite source (60) d'énergie en courant continu lorsque le court-circuit de l'assemblage de cathodes a disparu.

10. Système selon la revendication 9, caractérisé en ce que lesdits premiers et seconds moyens (68,70; 80 à 86) de commutation sont des commutateurs à commande par relais et en ce que lesdits moyens (90) de commande comprennent un commutateur (92) pouvant être commandé de façon sélective pour effectuer l'actionnement des commutateurs à commande par relais respectifs.

11. Système selon la revendication 9, caractérisé en ce que lesdits moyens (110 à 114) de commande comprennent des moyens (110) d'entrée-sortie pour surveiller les conditions de tension et de courant traduisant la présence et l'absence de court-circuitage de l'assemblage de cathodes, ainsi qu'un contrôleur de procédé (114) réagissant à la sortie desdits moyens (110) d'entrée-sortie pour actionner automatiquement de cette manière lesdits premiers et seconds moyens de commutation.

12. Système selon la revendication 8, 9, 10 ou 11, caractérisé en ce qu'il comprend des moyens (88) d'indication de court-circuit fournissant une indication de la persistance du court-circuitage de l'assemblage de cathodes au-delà d'une durée prédéterminée.

13. Système selon la revendication 8, 9, 10, 11 ou 12, caractérisé en ce que ladite source (72) d'énergie auxiliaire comprend une source de courant alternatif de grande puissance fournissant une tension de sortie insuffisante pour créer un plasma de pulvérisation.

14. Système selon la revendication 13, caractérisé en ce que ladite source (72) de courant alternatif de grande puissance comprend un transformateur abaisseur (74) muni d'un enroulement secondaire apte à être relié à l'assemblage (52 ou 54) de cathodes pour l'alimenter en énergie électrique.

15. Système selon la revendication 14, caractérisé en ce que, audit enroulement secondaire, sont reliés en série des moyens (88) formant ballast à limitation de courant adaptés pour agir au bout d'un retard temporel prédéterminé après le branchement de ladite source (72) de courant alternatif de grande puissance sur l'assemblage de cathodes, ledit retard temporel étant supérieur à la durée normalement requise pour permettre la vaporisation du dépôt court-circuitant.

16. Système selon l'une quelconque des revendications 8 à 15, dans lequel ladite chambre de pulvérisation renferme plus d'un assemblage de cathodes, caractérisé en ce qu'à ladite source (72) d'énergie auxiliaire sont associés des moyens (102) formant commutateur de sélection servant à relier la source (72) d'énergie auxiliaire sélectivement à l'un quelconque des assemblages (52, 54) de cathodes contenus dans la chambre (12) de pulvérisation.

**Patentansprüche**

1. Verfahren zum Entfernen einer kurzschlußerzeugenden Schicht aus leitendem Material von einer Zerstäubungskathodenvorrichtung, die in einer Zerstäubungskammer angeordnet ist und von einer Gleichstromquelle mit Energie versorgt wird, wobei die Energie ausreicht, um ein Zerstäubungsplasma zu erzeugen und aufrechtzuerhalten, gekennzeichnet durch die Schritte: (a) Unterbrechen der Gleichstromversorgung von der Gleichstromquelle auf die Kathodenvorrichtung, und (b) Aufbringen von elektrischer Energie auf die Kathodenvorrichtung, wobei die Energie ausreicht, um die Schicht zu verdampfen und nicht ausreicht, um ein Zerstäubungsplasma zu schaffen.

2. Verfahren nach Anspruch 1, dadurch gekennzeichnet, daß die elektrische Energie von einer Hochleistungs-Wechselstromquelle aufgebracht wird, die eine zum Erzeugen eines Zerstäubungsplasmas nicht ausreichende Ausgangsspannung aufweist.

3. Verfahren nach Anspruch 1 oder 2, dadurch gekennzeichnet, daß der Schritt (b) für eine vorbestimmte Zeitdauer fortgeführt wird, die normalerweise zum Verdampfen der kurzschlußerzeugenden Schicht ausreicht, und ihm dann der Schritt (c), das Wiederaufnehmen der Stromversorgung von der Gleichstromquelle zur Kathodenvorrichtung, folgt.

4. Verfahren nach Anspruch 3, gekennzeichnet durch das Überwachen von Parametern, die einen Kurzschluß der Kathodenvorrichtung anzeigen, und durch das Wiederholen der Schritte (a) und (b), falls die während des Schrittes (c) überwachten Parameter immer noch einen Kurzschluß der Kathodenvorrichtung anzeigen.

5. Verfahren nach Anspruch 4, dadurch gekennzeichnet, daß die Schritte (a), (b) und (c) eine bestimmte Anzahl mal wiederholt werden, und daß darauf folgend die Zerstäubungskammer abgeschaltet wird, falls die überwachten Parameter, nachdem die Schritte (a), (b) und (c) eine bestimmte Anzahl mal wiederholt wurden, immer noch einen Kurzschluß der Kathodenvorrichtung anzeigen.

6. Verfahren nach Anspruch 3, 4 oder 5, dadurch gekennzeichnet, daß eine erste Pause zwischen den Schritten (a) und (b) und eine zweite Pause zwischen den Schritten (b) und (c) eingeführt wird.

7. Verfahren nach Anspruch 3, 4, 5 oder 6, dadurch gekennzeichnet, daß der Schritt (c) ein Hochfahren der Gleichstromquelle gemäß einem vorbestimmten Spannungsprofil enthält.

8. Anordnung zum Entfernen einer kurzschlußerzeugenden Schicht aus leitfähigem Material von einer Zerstäubungskathodenvorrichtung, die in einer Zerstäubungskammer angeordnet ist und mit einer Gleichstromquelle verbunden ist, wobei deren Energie ausreicht, um ein Zerstäubungsplasma in der Zerstäubungskammer zu erzeugen und aufrechtzuerhalten, gekennzeichnet durch eine Hilfsstromquelle (72), die elektrische Energie liefern kann, die ausreicht, um die kurzschlußerzeugende Schicht zu verdampfen und nicht ausreicht, um ein Zerstäubungsplasma zu erzeugen; und Mittel (68-86, 90 oder 110-114) zum alternativen Verbinden der Gleichstromquelle (60) oder der Hilfsstromquelle (72) mit der Kathodenvorrichtung (52 oder 54).

9. Anordnung nach Anspruch 8, dadurch gekennzeichnet, daß die Mittel zum Verbinden ein erstes Schaltmittel (68, 70), das zwischen der Gleichstromquelle (60) und der Kathodenvorrichtung (52 oder 54) verbunden angeordnet ist, ein zweites Schaltmittel (80-86), das zwischen der Hilfsstromquelle (72) und der Kathodenvorrichtung verbunden angeordnet ist, und Steuermittel (90 oder 110-114) aufweist, die das erste und zweite Schaltmittel derart steuern, daß sie die Stromversorgung von der Gleichstromquelle (60) zur Kathodenvorrichtung (52; 54) unterbrechen und die letztere mit der Hilfsstromquelle (72) verbinden, wenn die Kathodenvorrichtung kurzgeschlossen wird, und daß sie die Hilfsstromquelle (72) von der Kathodenvorrichtung trennen und die Stromversorgung von der Gleichstromquelle (60) zur Kathodenvorrichtung wiederherstellen, wenn der Kurzschluß der Kathodenvorrichtung aufgehoben ist.

10. Anordnung nach Anspruch 9, dadurch gekennzeichnet, daß das erste und das zweite Schaltmittel (68,70; 80-86) relaisbetriebene Schalter sind, und das Steuermittel (90) einen selektiv betätigbaren Schalter (92) enthält, der die Betätigung der jeweiligen Relaisschalter bewirkt.

11. Anordnung nach Anspruch 9, dadurch gekennzeichnet, daß das Steuermittel (110-114) ein Eingangs- und Ausgangmittel (110) zum Überwachen von Spannungs- und Stromverhältnissen, die das Vorhandensein und das Nichtvorhandensein eines Kurzschlusses der Kathodenvorrichtung widerspiegeln, und einen Prozessregler (114) enthält, der auf den Ausgang des Eingangs-und Ausgangmittels (110) reagiert, indem er automatisch das erste und das zweite Schaltmittel auf diese Weise betätigt.

12. Anordnung nach Anspruch 8, 9, 10 oder 11, gekennzeichnet durch ein kurzschlußanzeigendes Mittel (88), das eine Anzeige eines andauernden, eine bestimmte Zeitdauer übersteigenden Kurzschlusses liefert.

13. Anordnung nach Anspruch 8, 9, 10, 11 oder 12, dadurch gekennzeichnet, daß die Hilfsstromquelle (72) eine Hochleistungs-Wechselstromquelle umfaßt, die eine Ausgangsspannung bereitstellt, welche zum Erzeugen eines Zerstäubungsplasmas nicht ausreicht.

14. Anordnung nach Anspruch 13, dadurch gekennzeichnet, daß die Hochleistungs-Wechselstromquelle (72) einen Abwärtstransformator (74) mit einer Sekundärwicklung aufweist, die derart angepaßt ist, um mit der Kathodenvorrichtung (52 oder 54) verbunden zu werden und um diese mit elektrischer Energie zu versorgen.

15. Anordnung nach Anspruch 14, dadurch gekennzeichnet, daß die Sekundärwicklung einen in Reihe geschalteten strombegrenzenden Ballastwiderstand (88) aufweist, der mit einer bestimmten Zeitverzögerung nach Verbindung der Hochleistungs-Wechselstromquelle (72) mit der Kathodenvorrichtung wirksam werden kann, wobei die Zeitverzögerung die normalerweise erforderliche Zeitspanne zum Verdampfen der kurzschlußerzeugenden Schicht übersteigt.

16. Anordnung nach einem der Ansprüche 8 bis 15, wobei die Zerstäubungskammer mehr als eine der Kathodenvorrichtungen enthält, dadurch gekennzeichnet, daß.die Hilfsstromquelle (72) eine ihr zugeordnete Wahlschalteinrichtung (102) zum selektiven Verbinden der Hilfsstromquelle (72) an eine beliebige der Kathodenvorrichtungen (52,54) innerhalb der Zerstäubungskammer (12) aufweist.

Fig.1

Fig.2

EP 0 213 716 B1

Fig.3

Fig.4

## FIG. 5(a)

## FIG. 5(b)

## FIG. 5(c)

## FIG. 5(d)

# Fig. 6

# Fig. 7

15